# EUROPEAN PATENT APPLICATION

(11) **EP 2 925 099 A1**
(43) Date of publication of application: **30.09.2015**
(21) Application number: 15160857.7
(22) Date of filing: 25.03.2015
(51) Int. Cl.: H05K 1/02

(54) **Multicolor printing**

(30) Priority: 26.03.2014 US 201461970429 P
(71) Applicant: Camtek LTD., 23150 Migdal-Haemek (IL)
(72) Inventor: Ben-Abu, Yehuda, 4235326 Netanya (IL); Ozeri, Yair, 4630571 Herzliya (IL)
(74) Representative: Modiano, Micaela Nadia

(57) **Abstract**

A method for printing materials of multiple colors on an electrical circuit that comprises multiple regions of different functionalities, the method comprises: receiving or generating a printing scheme that defines a mapping between a functionality of a region and a color; and printing, by a printer module, according to the printing scheme and during a manufacturing process of the electrical circuit, at least some of the materials of the multiple colors on the multiple regions of the electrical circuit to provide an electrical circuit in which adjacent regions of different functionality are printed with materials of different colors of the multiple colors.

## Description

### RELATED APPLICATIONS

This application claims priority from US provisional patent serial number 61/970,429 filing date March 26, 2014 which is incorporated herein by reference.

### BACKGROUND OF THE INVENTION

One of the processes of manufacturing substrates that include conductive and non-conductive layers, for example PCB panels, is placement a solder mask (SM) all over the substrate. Conventionally, the formation of the SM may include coating the entire PCB with the SM and exposing the SM to light according to a desired pattern either directly with a laser printer or indirectly by shining light through a prepared artwork film. In one instance, the unexposed area of the SM is washed away, and the remaining SM is finally cured. In another instance, the exposed area is washed away and the remaining SM is further cured. In either case, inaccurate alignment, multiple handling, the need to manufacture accurate artworks result in costly, inefficient, and where PCBs have very small features impossible to manufacture.

Inkjet application of SM circumvents all of the above problems and enables efficient manufacturing with low cost and high yield. Using inkjet, direct deposition of the SM is made only where it is needed, and after automatic alignment of the print heads and computer provided images with the acquired images of copper features on the PCB using digital means.

Materials that can be used for legend printing and that can be deposited using inkjet methods are described in PCT patent application PCT/IL01/0116, publication serial number WO00246323A2 of Zohar et al., Titled "UV CURABLE INK-JET LEGEND INK FOR PRINTING ON PRINTED CIRCUIT BOARD".

One of the processes of manufacturing PCB is provided in PCT patent application WO2009060441 of Muhammed et al.

Currently solder mask material is always one color.

### SUMMARY

According to an embodiment of the invention there may be provided a method for printing materials of multiple colors on an electrical circuit that comprises multiple regions of different functionalities, the method comprises: receiving or generating a printing scheme that defines a mapping between a functionality of a region and a color; and printing, by a printer module, according to the printing scheme and during a manufacturing process of the electrical circuit, at least some of the materials of the multiple colors on the multiple regions of the electrical circuit to provide an electrical circuit in which adjacent regions of different functionality are printed with materials of different colors of the multiple colors.

According to an embodiment of the invention there may be provided a method for printing solder mask materials of multiple colors on a printed circuit board (PCB), the method comprises: receiving or generating a printing scheme that defines a mapping between multiple areas of the PCB and solder mask materials of multiple colors, wherein at least two different areas of the PCB are mapped to solder mask materials of at least two different colors; and printing, by an inkjet printer, the solder mask materials of multiple colors in accordance with the printing scheme to provide a PCB that comprises the at least two different areas, wherein the at least two different areas differ from each other by a color of solder mask applied on the areas.

According to an embodiment of the invention there may be provided a printer that comprises a controller, and one or more print heads; wherein the controller is configured to (a) receive a printing scheme that defines a mapping between multiple areas of the PCB and solder mask materials of multiple colors, wherein at least two different areas of the PCB are mapped to solder mask materials of at least two different colors; and (b) control a printing, by the one or more print heads, of the solder mask materials of multiple colors in accordance with the printing scheme to provide a PCB that comprises the at least two different areas, wherein the at least two different areas differ from each other by a color of solder mask applied on the areas.

According to an embodiment of the invention there may be provided a printer that comprises a controller, and one or more print heads; wherein the controller is configured to (a) receive or generate a printing scheme that defines a mapping between a functionality of a region of an electrical circuit and a color of an ink; wherein the electrical circuit comprises multiple regions of different functionalities; and (b) to control a printing, by the one or more print heads, of the electrical circuit, according to the printing scheme and during a manufacturing process of the electrical circuit, multiple colored inks of the multiple colors on the multiple regions of the electrical circuit to provide an electrical circuit in which adjacent regions of different functionality are printed with colored inks of different colors.

### BRIEF DESCRIPTION OF THE INVENTION

The present invention will be understood and appreciated more fully from the following detailed description taken in conjunction with the drawings in which:
FIG. 1 illustrates a method according to an embodiment of the invention;
FIG. 2 illustrates an inkjet printer according to an embodiment of the invention;
FIG. 3 illustrates a multi-colored PCB according to an embodiment of the invention;
FIG. 4 illustrates a multi-colored PCB according to an embodiment of the invention;
FIG. 5 illustrates a multi-colored PCB according to an embodiment of the invention;
FIG. 6 illustrates multiple print heads, a scan pattern and a multi-colored PCB according to an embodiment of the invention; and
FIG. 7 illustrates multiple print heads, a scan pattern and a multi-colored PCB according to an embodiment of the invention.

### DETAILED DESCRIPTION OF THE INVENTION

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

In the following specification, the invention will be described with reference to specific examples of embodiments of the invention. It will, however, be evident that various modifications and changes may be made therein without departing from the broader spirit and scope of the invention as set forth in the appended claims.

According to an embodiment of the invention one or more materials of multiple colors may be printed on an electrical circuit that may include regions of different functionality. Non-limiting example of such as electrical circuit may include a printed circuit board (PCB). For convenience of explanation some of the following examples will refer to a PCB. This is merely a non-limiting example of an electrical circuit that may include regions of different functionality.

The materials of multiple colors may differ from each other by color. One or more of these materials may be an (electrically) conductive material while one or more of these materials may be a non-conductive material. A solder mask ink is a non-limiting example of a non-conductive material. For convenience of explanation some of the following examples will refer to a solder mask ink. This is merely a non-limiting example of a material that may be printed on the electrical circuit that may include regions of different functionality.

A printer may be an inkjet printer or any printer that may accurately print the materials of multiple colors at desired locations. An inkjet printer is a non-limiting example of such a printer. For convenience of explanation some of the following examples will refer to an inkjet printer. This is merely a non-limiting example of a printer that may accurately print materials of different colors at desired locations.

Materials of multiple colors (or of different colors) may multiple materials that differ from each other by color. One or more of these materials may be a monochromatic material. Additionally or alternatively - one or more of these materials may be a multi-color material.

A method may be provided and may include (I) receiving or generating a printing scheme that defines the colors of material to be printed on areas of a PCB; and (II) executing the printing scheme thereby providing a PCB with areas on which materials of different colors is applied.

There is provided a system that prints materials only in the places that require such printing. The system controls the placement of the materials of multiple colors and this enable the system to print different colors on the same PCB panel.

The multi-color printing allows differentiation between different areas of the PCB. For example - green solder mask will be printed at digital area, blue solder mask will be printed at for analog area, red solder mask will be printed at high voltage area, and the like.

The printing of different colors of areas that differ from each other by functionality assist in monitoring the PCB during various processes including PCB inspection, monitoring of an assembly process during which electrical components are connected to the PCB, and during electrical testing in which an electrical circuit that includes the PCB is tested. This may speed up any testing procedure and increase the accuracy of any monitoring process that may be location dependent.

The areas and their corresponding colors may be determined and then a printing scheme may be implemented thereby printing areas with their corresponding colors. The areas may be represented by their coordinates in order to facilitate accurate printing at these areas.

The printing system may include an ink delivery system, print heads (such as inkjet heads) and have a data path for each color. The system may have the same number of print heads (or different number of print heads) per color. The system may be arranged to print all colors simultaneous by an array of print heads dedicated to different colors.

The print head may be moved during the printing process, the PCB may be moved during the printing process, both printing heads and PCB may be moved during the printing process or both can be maintain at the same position during the printing process.

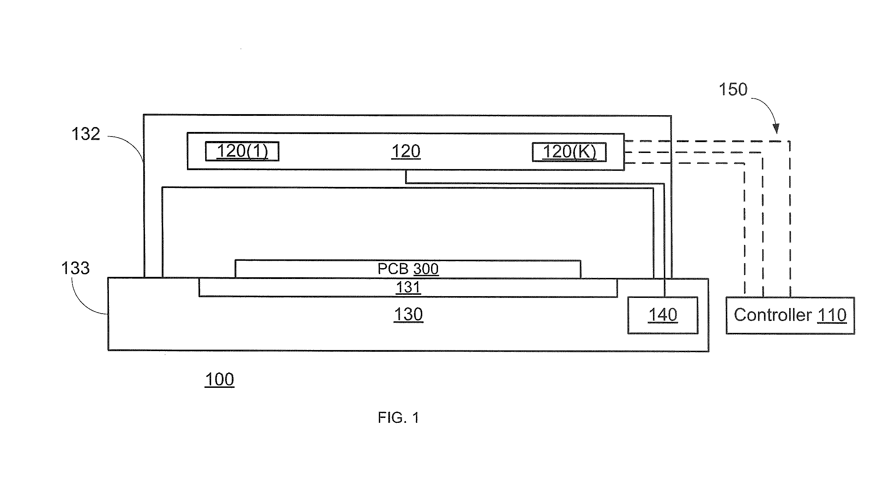

Figure 1 illustrates an inkjet printer 100 according to an embodiment of the invention.

Inkjet printer 100 may include a controller 110, one or more print heads such as multiple print heads that are collectively denoted 120, mechanical structure 130 for supporting the PCB and the multiple print heads 120, ink delivery system 140 for supplying solder mask ink of different colors to the multiple print heads 120. The mechanical structure 130 may include one or more mechanical stages (such as mechanical stage 131 that supports PCB 200) for introducing a movement between the PCB and the multiple print heads 120. The mechanical structure may be shaped as a combination of a table 133 and a bridge 132. The bridge 132 may be positioned above the table and may support the multiple print heads. The inkjet printer 100 may be of any other shape.

The multiple print heads 120 includes K print heads 120(1) - 120(K) that are arranged to print multiple J ink jets of different colors. J and K are positive integers. J may equal K. J may exceed K. J may be smaller than K.

The K print heads may be arranged in a line array, in a grid array, in a staggered array or in any formation.

The inkjet printer may include a curing module (not shown) for curing the solder mask ink.

One or more print head may be a monochromatic print head. One or more print head may be a multi-color print head. One or more print head may be configured to inkjet solder mask inks of different colors at different points of time.

The controller 110 may be a hardware controller and may include one or more processors. Controller 110 is configured to control the operation of the inkjet printer 110 in order to apply the printing scheme. Controller 110 may be coupled to the multiple print heads 120 via one or more data paths 150. A data path may include conductors, buses or any other components for facilitating communication between the controller 110 and one or more of the multiple print heads. A data path may be allocated per print head, per color of solder mask ink, and the like.

Controller 110 is configured to (a) receive a printing scheme that defines a mapping between multiple areas of the PCB and solder mask inks of multiple colors, wherein at least two different areas of the PCB are mapped to solder mask inks of at least two different colors; and (b) control a printing, by the multiple print heads, of the solder mask inks of multiple colors in accordance with the printing scheme to provide a PCB that comprises the at least two different areas, wherein the at least two different areas differ from each other by a color of solder mask applied on the areas.

The multiple print heads 120 are configured to print, under the control of controller 110, solder mask inks of multiple colors in accordance with the printing scheme to provide a PCB that comprises the at least two different areas, wherein the at least two different areas differ from each other by a color of solder mask applied on the areas.

The multiple areas of the PCB differ from each other by functionality.

The inkjet printer may be configured to perform at least one of the following:
a. Print solder mask inks of different colors on at least two areas of the PCB out of a high voltage area of the PCB, a driver area of the PCB, a data processing area of the PCB and an interconnect area of the PCB.
b. Print solder mask inks of different colors on each area out of a high voltage area of the PCB, a driver area of the PCB, a data processing area of the PCB and an interconnect area of the PCB.
c. Print solder mask inks of different colors on at least two areas out of a digital area of the PCB, an analog area of the PCB and a high voltage area of the PCB.
d. Print the solder mask inks of multiple colors by performing multiple printing iterations; wherein each printing iteration is allocated for printing a solder mask ink of a single color.
e. Print the solder mask inks of multiple colors by performing at least one printing iterations; wherein each printing iterations is allocated for printing at least two solder mask inks of different colors.

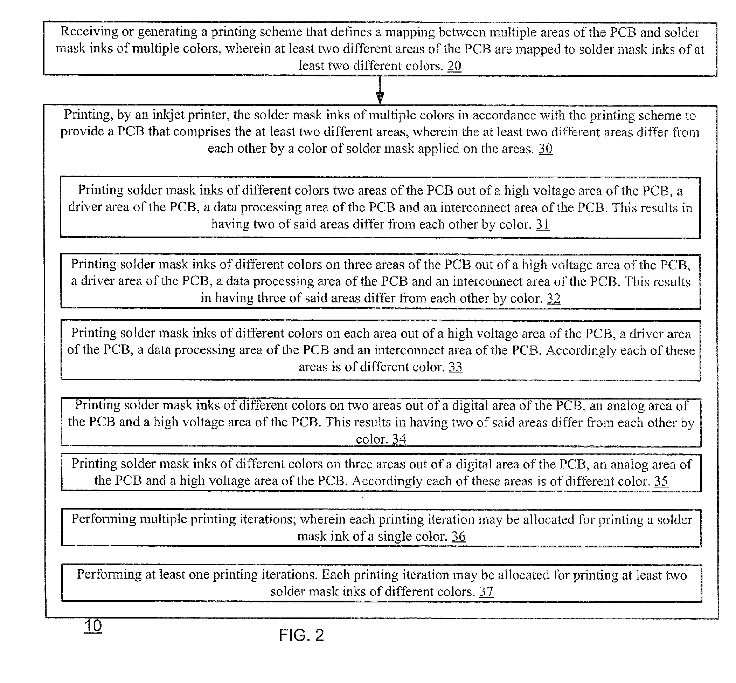

Figure 2 illustrates a method 10 according to an embodiment of the invention.

Method 10 may start by step 20 of receiving or generating a printing scheme that defines a mapping between multiple areas of the PCB and solder mask inks of multiple colors, wherein at least two different areas of the PCB are mapped to solder mask inks of at least two different colors.

Step 20 may include receiving the printing scheme by an inkjet printer.

The printing scheme can be a set of commands that once executed by the inkjet printer will result in a multiple color PCB.

The printing scheme may be generated by the inkjet printer in response to information about the location of each area to be printed with a solder mask and a requested mapping between areas and solder masks color. The generating of the printing scheme may include converting these inputs to instructions that map associated coordinates of the PCB with desired solder mask color.

Step 20 may be followed by step 30 of printing, by an inkjet printer, the solder mask inks of multiple colors in accordance with the printing scheme to provide a PCB that comprises the at least two different areas, wherein the at least two different areas differ from each other by a color of solder mask applied on the areas.

It is noted that two or more areas of the PCB may be of the same color but at least two areas of the PCB are coated with solder masks of different colors.

According to an embodiment of the invention the multiple areas of the PCB (out of which at least two areas are coated with solder masks of different colors) differ from each other by functionality. Accordingly - the difference in colors may assist in differentiating between different functional areas of the PCB.

Step 30 may include at least one of the following steps (denoted 31- 37 in figure 2):
a. Printing solder mask inks of different colors two areas of the PCB out of a high voltage area of the PCB, a driver area of the PCB, a data processing area of the PCB and an interconnect area of the PCB. This results in having two of said areas differ from each other by color.
b. Printing solder mask inks of different colors on three areas of the PCB out of a high voltage area of the PCB, a driver area of the PCB, a data processing area of the PCB and an interconnect area of the PCB. This results in having three of said areas differ from each other by color.
c. Printing solder mask inks of different colors on each area out of a high voltage area of the PCB, a driver area of the PCB, a data processing area of the PCB and an interconnect area of the PCB. Accordingly each of these areas is of different color.
d. Printing solder mask inks of different colors on two areas out of a digital area of the PCB, an analog area of the PCB and a high voltage area of the PCB. This results in having two of said areas differ from each other by color.
e. Printing solder mask inks of different colors on three areas out of a digital area of the PCB, an analog area of the PCB and a high voltage area of the PCB. Accordingly each of these areas is of different color.
f. Performing multiple printing iterations; wherein each printing iteration may be allocated for printing a solder mask ink of a single color.
g. Performing at least one printing iterations. Each printing iteration may be allocated for printing at least two solder mask inks of different colors.

This method can be applied by the highly advanced inkjet printer Gryphon of Camtek Ltd. of Migdal Haemeq Israel.

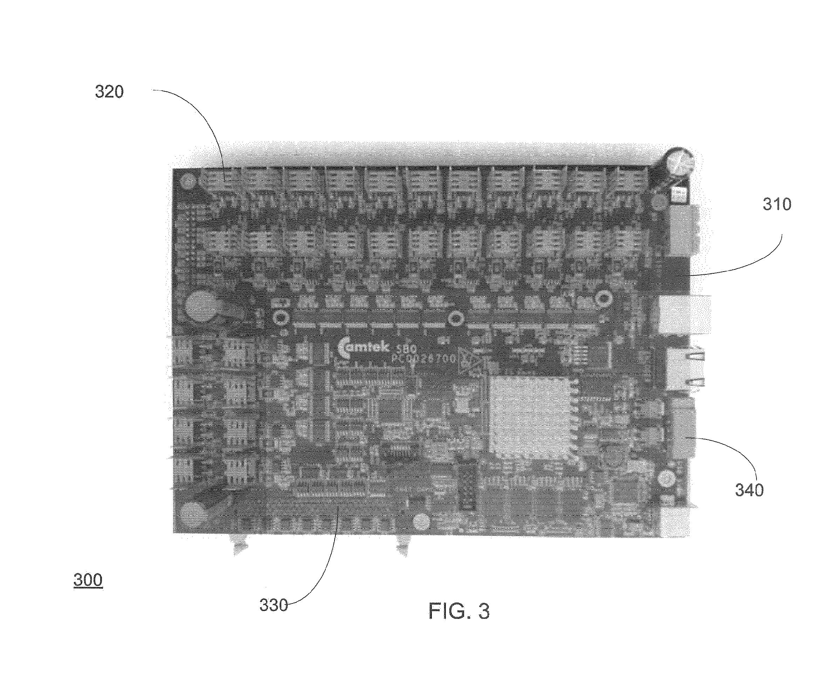

Figure 3 illustrates an example of a multi-color PCB 300 according to an embodiment of the invention. PCB 300 includes a high voltage area 310, a driver area 320, a data processing area 330 and an interconnect area 340. Each of these areas is covered with a solder mask of different color.

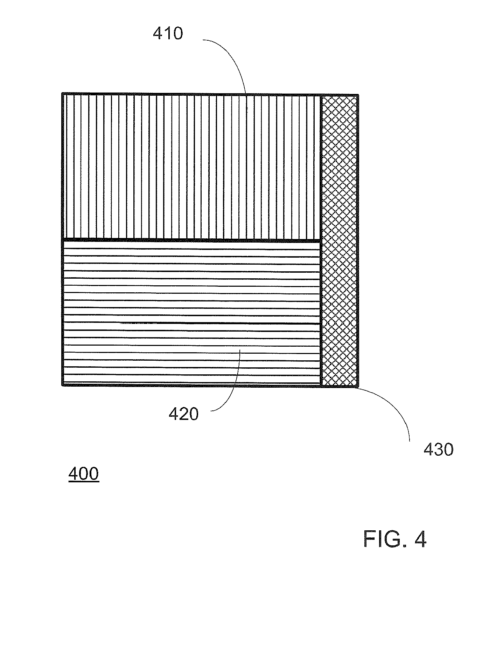

Figure 4 illustrates an example of a multi-color PCB 400 according to an embodiment of the invention. PCB 400 includes a digital area 410, an analog area 420 and a high voltage area 430. Each of these areas is covered with a solder mask of different color.

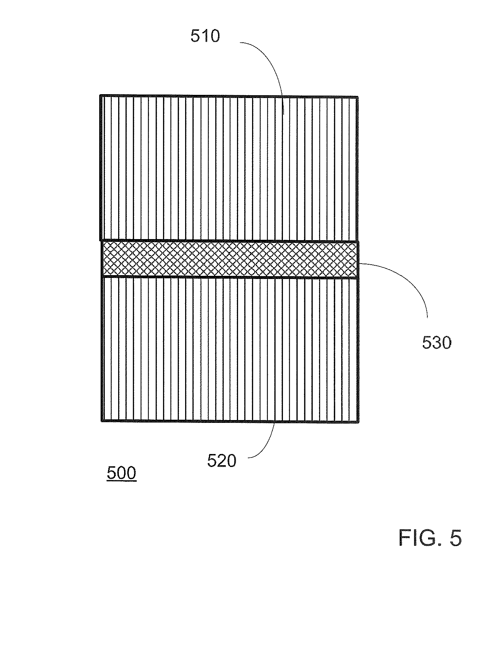

Figure 5 illustrates an example of a multi-color PCB 500 according to an embodiment of the invention. PCB 500 includes areas 510, 520 and 530. Areas 510 AND 520 are covered with a solder mask of a first color while a third area 530 is covered with a solder mask of a second color.

It is noted that the term area may refer to an area that exceeds a certain area threshold - such as being at least 1,5,10 or 20 percent of the area of the entire PCB.

It is noted that one or more areas that are covered with solder mask of different colors may differ from each other by shape and/or size. Alternatively, one or more areas that are covered with solder mask of different colors may be of a same shape and size.

Areas of the PCB may have any shape including a polygon, a curved shaped, an ellipse, a circle, and the like.

The solder mask inks of different colors may be visually distinguishable from each other.

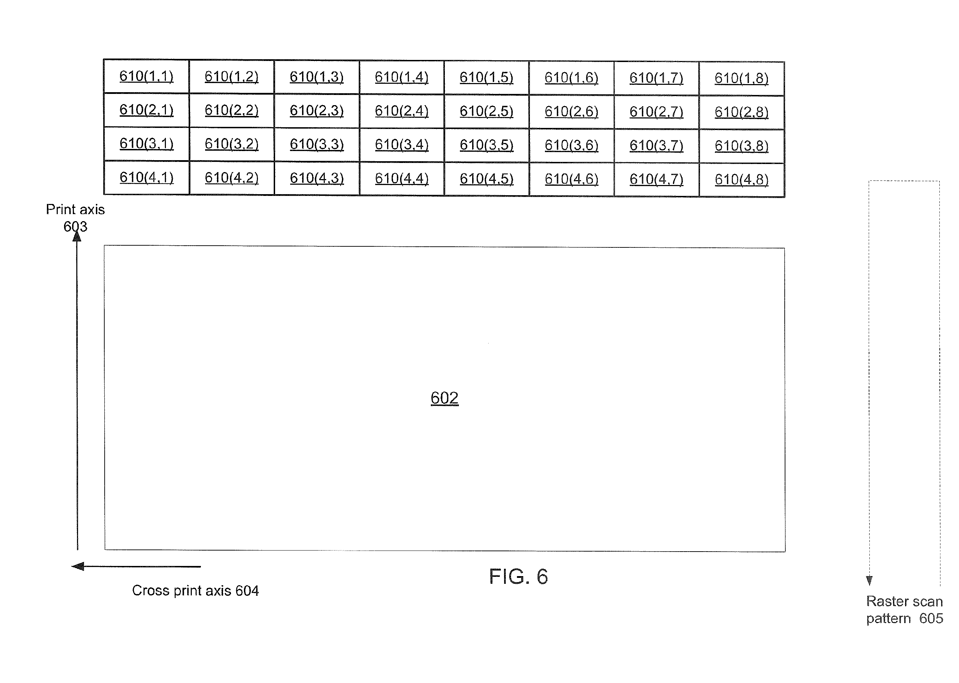

Figure 6 illustrates multiple print heads 610(1,1)- 610(4,8), a raster scan pattern 605 and a multi-colored PCB 602 according to an embodiment of the invention.

Figure 6 illustrates thirty two (K=32) print heads that are arranged in four rows and eight columns. The number of print heads may change from thirty two and the number of columns and rows may change from eight and four respectively.

Each row of the array is wide enough to cover the entire length of the PCB 602. During each print iteration the printing system introduces a movement along print axis 603 so that the entire PCB passes through the printing regions of the array. In order to expose the entire PCB to each one of the print heads there may be a need to perform multiple print iterations and between each print iteration the printing system introduces a movement along a cross print axis 604.

The number of print iterations may be determined in response to the printed scheme (especially the required pattern to be printed on the PCB) and the color that is printed by each one of the print heads.

The print heads may be arranged so that each row of print heads prints the same color and that at least one row prints a color that differs from a color printed by another row.

The print heads may be arranged so that each column of print heads prints the same color and that at least one column prints a color that differs from a color printed by another column.

The print heads may be arranged to that print heads that print the same color are distributed between multiple rows and columns.

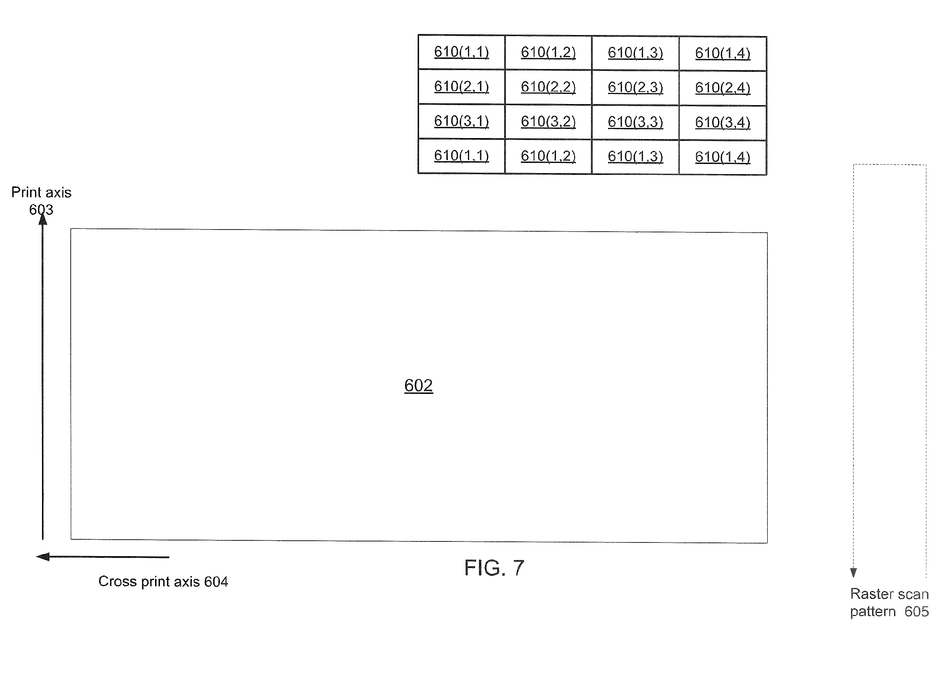

Figure 7 illustrates multiple print heads 610(1,1)- 610(4,4), a raster scan pattern 605 and a multi-colored PCB 602 according to an embodiment of the invention.

Figure 7 illustrates sixteen (K=32) print heads that are arranged in four rows and four columns. The number of print heads may change from sixteen and the number of columns and rows may change from four.

Each row of the array is wide enough to cover a half of PCB 602. During each print iteration the printing system introduces a movement along print axis 603 so that a half of the PCB passes through the printing regions of the array. In order to expose the entire PCB to each one of the print heads there may be a need to perform multiple print iterations and between each print iteration the printing system introduces a movement along a cross print axis 604. Fewer columns (in comparison to figure 6) mean that there will be more printing iterations and more movements along the cross print axis 604.

It is noted that each print head can print materials at a same area multiple times in order to create thicker level of material.

It is noted that during the printing the print heads may move or be static. The object may move or be static during the printing process.

Ink delivery system 140 may be configured to supply enough ink to the print heads so that even if an entire PCB should be coated with one color - the ink supplied to the print heads will facilitate a continuous and delay free printing of the entire PCB.

Furthermore, those skilled in the art will recognize that boundaries between the functionality of the above described operations are merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Thus, it is to be understood that the architectures depicted herein are merely exemplary, and that in fact many other architectures can be implemented which achieve the same functionality. In an abstract, but still definite sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected," or "operably coupled," to each other to achieve the desired functionality.

However, other modifications, variations, and alternatives are also possible. The specifications and drawings are, accordingly, to be regarded in an illustrative rather than in a restrictive sense.

The word "comprising" does not exclude the presence of other elements or steps then those listed in a claim. It is understood that the terms so used are interchangeable under appropriate circumstances such that the embodiments of the invention described herein are, for example, capable of operation in other orientations than those illustrated or otherwise described herein.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe.

Thus, these terms are not necessarily intended to indicate temporal or other prioritization of such elements. The mere fact that certain measures are recited in mutually different claims does not indicate that a combination of these measures cannot be used to advantage.

## Claims

1. A method for printing materials of multiple colors on an electrical circuit that comprises multiple regions of different functionalities, the method comprises:
receiving or generating a printing scheme that defines a mapping between a functionality of a region and a color; and
printing, by a printer module, according to the printing scheme and during a manufacturing process of the electrical circuit, at least some of the materials of the multiple colors on the multiple regions of the electrical circuit to provide an electrical circuit in which adjacent regions of different functionality are printed with materials of different colors of the multiple colors.

2. The method according to claim 1 wherein printer module comprises of an inkjet printer.

3. The method according to claim 1 wherein the materials of multiple colors are printed only on fractions of the multiple regions.

4. The method according to claim 1 wherein the printing scheme is responsive to a post-printing inspection scheme of the electrical circuit, wherein the post-printing inspections scheme is applied on the electrical circuit after the printing.

5. The method according to claim 1 wherein the electrical circuit is a printed circuit board (PCB).

6. The method according to claim 6 wherein at least one of the materials of the multiple colors is an electrically conductive material.

7. The method according to claim 6 wherein at least one of the materials of the multiple colors is an electrically non-conductive material.

8. The method according to claim 6 wherein at least one of the materials of the multiple colors is a solder mask ink.

9. A printer that comprises a controller, and one or more print heads; wherein the controller is configured to (a) receive a printing scheme that defines a mapping between multiple areas of the PCB and solder mask materials of multiple colors, wherein at least two different areas of the PCB are mapped to solder mask materials of at least two different colors; and (b) control a printing, by the one or more print heads, of the solder mask materials of multiple colors in accordance with the printing scheme to provide a PCB that comprises the at least two different areas, wherein the at least two different areas differ from each other by a color of solder mask applied on the areas.

10. A printed circuit board (PCB) that comprises multiple areas, wherein at least two areas of the PCB are covered with solder masks of different colors.

11. The PCB according to claim 10 wherein the multiple areas of the PCB differ from each other by functionality.

12. The PCB according to claim 10 wherein the at least two areas are selected of a group that consist of a high voltage area of the PCB, a driver area of the PCB, a data processing area of the PCB and an interconnect area of the PCB.

13. The PCB according to claim 10 wherein each area out of a high voltage area of the PCB, a driver area of the PCB, a data processing area of the PCB and an interconnect area of the PCB is covered with solder masks of different color.

14. The PCB according to claim 10 wherein the at least two areas are selected of a group that consist of a digital area of the PCB, an analog area of the PCB and a high voltage area of the PCB.

15. A printer that comprises a controller, and one or more print heads; wherein the controller is configured to (a) receive or generate a printing scheme that defines a mapping between a functionality of a region of an electrical circuit and a color of an ink; wherein the electrical circuit comprises multiple regions of different functionalities; and (b) to control a printing, by the one or more print heads, of the electrical circuit, according to the printing scheme and during a manufacturing process of the electrical circuit, multiple colored inks of the multiple colors on the multiple regions of the electrical circuit to provide an electrical circuit in which adjacent regions of different functionality are printed with colored inks of different colors.
